# EUROPEAN PATENT SPECIFICATION

(11) **EP 1 120 905 B1**
(45) Date of publication and mention of the grant of the patent: **22.09.2004**
(21) Application number: 00310745.5
(22) Date of filing: 04.12.2000
(51) Int. Cl.: H03F 3/191

(54) **Output amplifier for a voltage controlled oscillator**
Ausgangsverstärker für einen spannungsgesteuerten Oszillator
Amplificateur de sortie pour un oscillateur commandé en tension

(30) Priority: 11.01.2000 JP 2000006210
(43) Date of publication of application: 01.08.2001
(73) Proprietor: ALPS ELECTRIC CO., LTD., Ota-ku Tokyo 145 (JP)
(72) Inventor: Baba, Toshiki, c/o Alps Electric Co., Ltd., Ota-ku, Tokyo 145 (JP)
(74) Representative: Kensett, John Hinton

(56) References cited:
- WO-A-99/34505
- KUMAR B P ET AL: "A reduced size planar balun structure for wireless microwave and RF applications" CIRCUITS AND SYSTEMS, 1995., PROCEEDINGS., PROCEEDINGS OF THE 38TH MIDWEST SYMPOSIUM ON RIO DE JANEIRO, BRAZIL 13-16 AUG. 1995, NEW YORK, NY, USA,IEEE, US, 13 August 1995 (1995-08-13), pages 526-529, XP010165183 ISBN: 0-7803-2972-4

## Description

### BACKGROUND OF THE INVENTION

### 1. Field of the Invention

The present invention relates to a voltage controlled oscillator used in high-frequency apparatuses, and more particularly to a voltage controlled oscillator, used in a sending-receiving part constituting a portable apparatus such as a Cellular Phone, that outputs balanced oscillating signals.

### 2. Description of the Prior Art

Recently, the transformation of high-frequency circuit portions of high-frequency apparatuses such as Cellular Phones into a chip set has been evolving, contributing to making portable apparatuses compact and lightweight. Although voltage controlled oscillator used for sending and receiving in the portable apparatuses generally output unbalanced oscillating signals from an internal oscillating part, since a subsequent circuit, e.g., a mixer connected to the voltage controlled oscillators is generally of balanced type, the unbalanced oscillating signals outputted from the oscillating part are converted into balanced oscillating signals within the chip set.

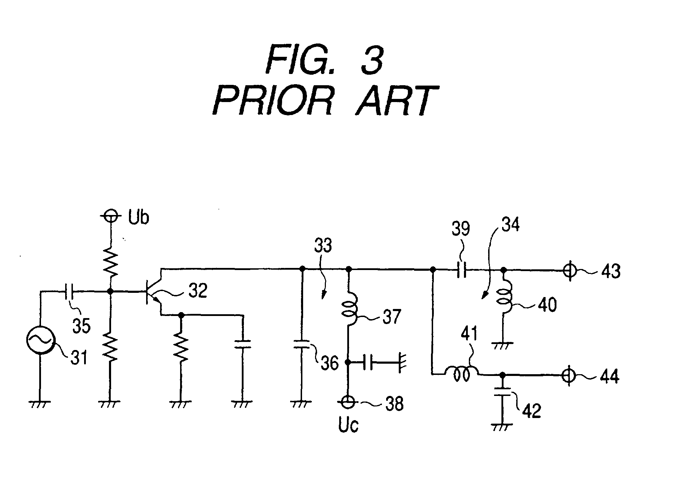

FIG. 3 is a schematic diagram of a conventional voltage controlled oscillator. In FIG. 3, the conventional voltage controlled oscillator comprises an oscillating part 31 outputting unbalanced oscillating signals, an amplifying transistor 32, a tuning circuit 33, and an unbalance to balance conversion circuit 34.

The oscillating part 31, with one end thereof grounded and the other outputting oscillating signals, is connected to the base of the amplifying transistor 32 via a DC cut capacitor 35. The amplifying transistor 32 constitutes, e.g., an NPN common emitter amplifying circuit, and the collector thereof is grounded by a tuning capacitor 36 and supplied with voltage from a collector voltage supplying terminal 38 via an inductance element 37 constituting the tuning circuit 33. A tuning frequency of the tuning circuit 33 is set to the same frequency as that of oscillating signals. The collector of the amplifying transistor 32 is connected to the unbalance to balance conversion circuit 34, which has a capacitor 39 and an inductance element 40 to constitute a high-pass phase-shift circuit for advancing the phase of oscillating signals by 90 degrees, and an inductance element 41 and a capacitor 42 to constitute a low-pass phase shift circuit for delaying the phase of oscillating signals by 90 degrees.

With the above configuration, an oscillating signal outputted from the oscillating part 31 is inputted to the base of the amplifying transistor 32, amplified by it, outputted to the collector thereof, and then inputted to the unbalance to balance conversion circuit 34 via the tuning circuit 33. An oscillating signal that leads the original oscillating signal by a phase angle of 90 degrees is outputted from an output terminal 43, and an oscillating signal that lags the original oscillating signal by a phase angle of 90 degrees is outputted from an output terminal 44. As a result, a phase difference between the oscillating signal outputted to the output terminal 43 and the oscillating signal outputted to the output terminal 44 is 180 degrees. Therefore, the voltage controlled oscillator with the output terminals 43 and 44 as output ends outputs balanced oscillating signals.

Other conventional known voltage controlled oscillators output balancedrpscillating signals by using the collectors of amplifying transistors of an emitter-coupled differential amplifying circuit (not shown) as output ends. Document WO 9 934 505 discloses an oscillator followed by a balanced to unbalanced transformer comprising an unbalanced stripline input and a balanced stripline output.

Conventional voltage controlled oscillators have many parts to use the tuning circuit 33 and the unbalance to balance conversion circuit 34, hampering the development of compact and lightweight portable apparatuses. Since harmonics occurring in the oscillating part 31 are directly outputted, new distortions occur due to the harmonics during mixing with other signals in a subsequent circuit, e.g., a mixer (not shown), interfering with desired output signals from the mixer. Also, to make a phase difference between oscillating signals exactly equal to 180 degrees, constants of parts used in the unbalance to balance conversion circuit 34 must be tightly managed.

### SUMMARY OF THE INVENTION

The present invention has been made to solve the above problem and provides a voltage controlled oscillator that has a low parts count and less harmonic distortion, and is easy in constant management.

To solve the above problem, a voltage controlled oscillator comprises an oscillating part that outputs unbalanced oscillating signals, a first microstrip line whose length is one-fourth the wavelength of the oscillating signals, and a second microstrip line whose length is half the wavelength of the oscillating signals, wherein the entirety of the first microstrip line and the second microstrip line in a range from an end thereof to a center point lengthwise thereof are opposed to each other and electromagnetically coupled, one end of the first microstrip line corresponding to the center point of the second microstrip line is RF-grounded, the unbalanced oscillating signals are inputted to the other end of the first microstrip line, and balanced oscillating signals are outputted from respective ends of the second microstrip line.

The voltage controlled oscillator may include a multilayer substrate on which the first microstrip line and the second microstrip line are disposed, wherein the multilayer substrate has a grounded conductive layer and first and second insulating layers laminated above and below the conductive layer, wherein, on the upper surface of the first insulating layer, the first microstrip line and a portion of the second microstrip line in a range from a center point thereof to one end are opposed to each other and electromagnetically coupled, while, on the lower surface of the second insulating layer, a portion of the second microstrip line in a range from the center point to the other end is provided, wherein an end of the portion of the second microstrip line corresponding to an RF-grounded end of the first microstrip line on the upper surface of the first insulating layer and either end of the portion of the second microstrip line on the lower surface of the second insulating layer are brought into conduction by a through hole.

### BRIEF DESCRIPTION OF THE DRAWINGS

Preferred embodiments of the present invention will be described in detail based on the followings, wherein:
FIG. 1 is a schematic diagram of a voltage controlled oscillator of the present invention;
FIG. 2 shows an example of disposing a first microstrip line and a second microstrip line in the voltage controlled oscillator of the present invention on a multilayer substrate; and
FIG. 3 is a schematic diagram of a conventional voltage controlled oscillator;

### DESCRIPTION OF THE PREFERRED EMBODIMENTS

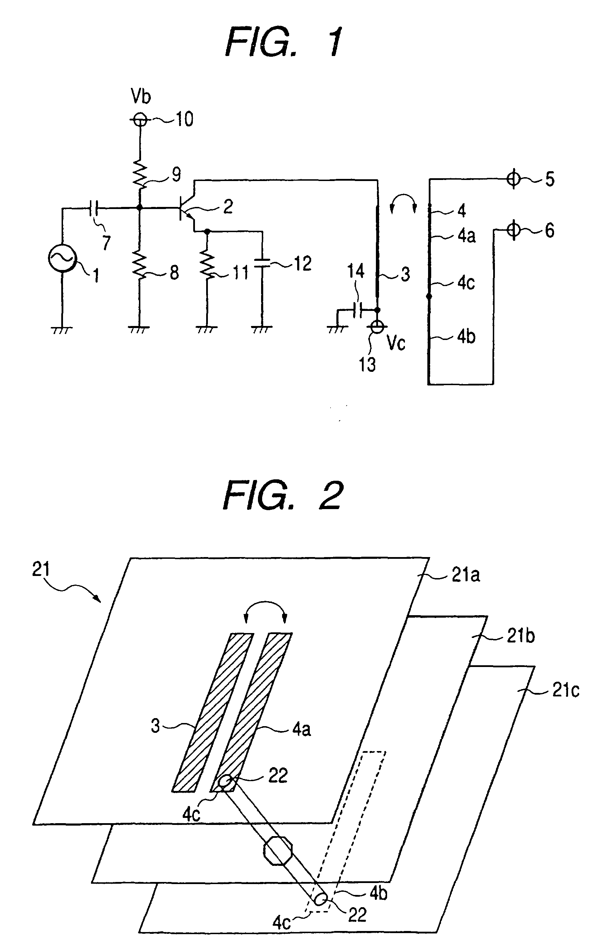

Hereinafter, an embodiment of a voltage controlled oscillator of the present invention will be described with reference to FIGS. 1 and 2.

FIG. 1 is a schematic diagram of a voltage controlled oscillator of the present invention. In FIG. 1, the voltage controlled oscillator of the present invention comprises an oscillating part 1 that outputs unbalanced oscillating signals, an amplifying transistor 2, a first microstrip line 3 whose length is one-fourth the wavelength of the oscillating signals outputted from the oscillating part 1, a second microstrip line 4 whose length is half the wavelength of the oscillating signals outputted from the oscillating part 1, and output terminals 5 and 6 at each end of the microstrip line 4. The microstrip line 4, which has a center point 4c lengthwise thereof, comprises a portion from one end of the microstrip line 4 to the center point 4c (hereinafter referred to as "microstrip line 4a"), and a portion from the other end of the microstrip line 4 to the center point 4c (hereinafter referred to as "microstrip line 4b"). The microstrip lines 3 and 4 are constructed of, e.g., copper foils formed in stripes on a multilayer substrate.

The oscillating part 1, constituted by, e.g., a Colpitts voltage controlled oscillating circuit, is grounded at one end and connected to the base of the amplifying transistor 2 via a DC cut capacitor 7 at the other end. The amplifying transistor 2 constitutes, e.g., an NPN common emitter amplifying circuit, and the base thereof is grounded via a base bias resistor 8 and connected with a base voltage supplying terminal 10 via a base bias resistor 9. The emitter thereof is grounded via a bias resistor 11 and grounded via a bias capacitor 12. Furthermore, the collector is connected with a collector voltage supplying terminal 13 via the microstrip line 3. The collector voltage supplying terminal 13 is grounded via a DC cut capacitor 14. In other words, the microstrip line 3 is RF-grounded via the DC cut capacitor 14 at one end and supplied with an oscillating signal via the amplifying transistor 2 at the other end. The microstrip line 3 and the microstrip line 4a are opposed lengthwise to each other and electromagnetically coupled. As a result, the center point 4c of the microstrip line 4 is virtually RF-grounded. The output terminals 5 and 6 at each end of the microstrip line 4 are output ends of the voltage controlled oscillator, and are connected to a subsequent circuit, e.g., a mixer (not shown) so that oscillating signals are outputted to the mixer.

With the above configuration, an unbalanced oscillating signal outputted from the oscillating part 1 is inputted to the base of the amplifying transistor 2, is amplified by the amplifying transistor 2, and is outputted to the collector thereof. Next, the oscillating signal outputted to the collector of the amplifying transistor 2 is transmitted to the microstrip line 3 and is transmitted with the same phase to the microstrip line 4a electromagnetically coupled with the microstrip line 3. Here, since the microstrip line 4 is virtually grounded at the center point 4c, the oscillating signal is transmitted with an opposite phase to the microstrip line 4b, so that the oscillating signals are outputted to the output terminals 5 and 6 at each end of the microstrip line 4.

By the way, since the length of the microstrip line 3 is one-fourth the wavelength of an oscillating signal outputted from the oscillating part 1 and one end of the microstrip line 3 is grounded, the oscillating signal has a maximum amplitude at the other end of the microstrip line 3. Since this signal is transmitted with the same phase to the microstrip line 4a electromagnetically coupled with the microstrip line 3 and is transmitted with an opposite phase to the microstrip line 4b, a phase difference of 180 degrees exists between an oscillating signal outputted to the output terminal 5 and an oscillating signal outputted to the output terminal 6. In short, the voltage controlled oscillator with the output terminals 5 and 6 as output terminals output balanced oscillating signals. Furthermore, since the voltage controlled oscillator has as few redundant elements as possible, that is, a low parts count, it is easy to manufacture compact and lightweight portable apparatuses. Also, the small number of redundant elements makes the voltage controlled oscillator easy in constant management.

Furthermore, since the tuning circuit and the unbalance to balance conversion circuit are achieved by using the microstrip lines 3 and 4, even harmonics are cut and not outputted because a phase difference between an oscillating signal outputted to the output terminal 5 and an oscillating signal outputted to the output terminal 6 is a multiple of 360 degrees, meaning the same phase. Therefore, since oscillating signals from which distortions due to even harmonics are eliminated can be outputted, interference during mixing with other signals in a subsequent circuit, e.g., a mixer, can be minimized.

FIG. 2 shows an example of disposing the microstrip lines 3 and 4 in the voltage controlled oscillator of the present invention on a multilayer substrate. In FIG. 2, the voltage controlled oscillator of the present invention includes a multilayer substrate 21 on which the microstrip lines 3 and 4 are disposed. The multilayer substrate 21 includes a grounded conductive layer 21b (hereinafter referred to as "ground layer") and, a first insulating layer 21a and a second insulating layer 21c which are laminated above and below the ground layer.

On the upper surface of the first insulating layer 21a, the microstrip lines 3 and 4 are opposed to each other lengthwise, and are electromagnetically coupled so that an RF-grounded end of the microstrip line 3 corresponds with an end closer to the original center point 4c of the microstrip line 4a. Next, on the lower surface of the second insulating layer 21c is provided the microstrip line 4b. Furthermore, the end closer to the original center point 4c of the microstrip line 4a and an end closer to the original center point 4c of the microstrip line 4b are brought into conduction via, e.g., a through hole 22. The microstrip line 3 and the microstrip line 4b are not electromagnetically coupled because of the intervening ground layer 21b.

The above configuration results in the same circuit as that of FIG. 1, and the microstrip lines 3, 4a, and 4b, and the through hole 22 can be disposed on the multilayer substrate 21 by printed wiring technology, so that the voltage controlled oscillator having a low parts count is achieved.

As has been described above, a voltage controlled oscillator of the present invention comprises an oscillating part that outputs unbalanced oscillating signals, a first microstrip line whose length is one-fourth the wavelength of the oscillating signals, and a second microstrip line whose length is half the wavelength of the oscillating signals, wherein the entirety of the first microstrip line and the second microstrip line from an end thereof to a center point lengthwise thereof are opposed to each other and electromagnetically coupled, one end of the first microstrip line corresponding to the center point of the second microstrip line is RF-grounded, the unbalanced oscillating signals are inputted to the other end of the first microstrip line, and balanced oscillating signals are outputted from respective ends of the second microstrip line. Thereby, a parts count is reduced, so that portable apparatuses and the like can be made compact and lightweight. Also, since less distorted oscillating signals from which even harmonics are cut can be outputted, interference during mixing with other signals in a subsequent circuit, e.g., a mixer, can be minimized. Furthermore, the low parts count makes constant management easy.

Furthermore, the voltage controlled oscillator further includes a multilayer substrate on which the first microstrip line and the second microstrip line are disposed, wherein the multilayer substrate has a grounded conductive layer and first and second insulating layers laminated above and below the conductive layer, wherein, on the upper surface of the first insulating layer, the first microstrip line and a portion of the second microstrip line in a range from a center point thereof to one end are opposed to each other and electromagnetically coupled, while, on the lower surface of the second insulating layer, a portion of the second microstrip line in a range from the center point to the other end is provided, wherein an end of the portion of the second microstrip line corresponding to an RF-grounded end of the first microstrip line on the upper surface of the first insulating layer and either end of the portion of the second microstrip line on the lower surface of the second insulating layer are brought into conduction by a through hole. Thereby, since the microstrip lines can be disposed on the multilayer substrate by printing technology, a parts count is reduced, so that portable apparatuses and the like can be made compact and lightweight.

## Claims

1. A voltage controlled oscillator, comprising:
an oscillating part that outputs unbalanced oscillating signals;
a first microstrip line (3) whose length is one-fourth the wavelength of the oscillating signals; and
a second microstrip line (4) whose length is half the wavelength of the oscillating signals, wherein:
the entirety of the first microstrip line (3) and the second microstrip line (4) in a range (4a) from an end thereof to a center point (4c) lengthwise thereof are opposed to each other and electromagnetically coupled;
one end of the first microstrip line corresponding to the center point (4c) of the second microstrip line is RF-grounded; the unbalanced oscillating signals are inputted to the other end of the first microstrip line; and
balanced oscillating signals are outputted from respective ends of the second microstrip line (5, 6).

2. The voltage controlled oscillator according to claim 1, including a multilayer substrate (21) on which the first microstrip line (3) and the second microstrip line (4) are disposed, wherein:
the multilayer substrate (21) has a grounded conductive layer (21b) and first (21a) and second (21c) insulating layers laminated above and below the conductive layer (21b);
on the upper surface of the first insulating layer (21a), the first microstrip line (3) and a portion (4a) of the second microstrip line (4) in a range from a center point (4c) thereof to one end are opposed to each other and electromagnetically coupled;
on the lower surface of the second insulating layer (21c), a portion (4b) of the second microstrip line (4) in a range from the center point (4c) to the other end is provided; and
an end of the portion (4a) of the second microstrip line (4) corresponding to an RF-grounded end of the first microstrip line (3) on the upper surface of the first insulating layer (21a) and either end of the portion (4b) of the second microstrip line on the lower surface of the second insulating layer (21c) are brought into conduction by a through hole (22).

## Patentansprüche

1. Spannungsgesteuerter Oszillator, aufweisend:
einen Schwingungsteil, der unsymmetrische Schwingungssignale ausgibt;
eine erste Mikrostreifenleitung (3), deren Länge ein Viertel der Wellenlänge der Schwingungssignale ist; und
eine zweite Mikrostreifenleitung (4), deren Länge eine Hälfte der Wellenlänge der Schwingungssignale ist, wobei:
die Gesamtheit der ersten Mikrostreifenleitung (3) und der zweiten Mikrostreifenleitung (4) in einem Bereich (4a) von einem Ende davon bis zu einem Mittenpunkt (4c) in Längenrichtung davon einander entgegengesetzt und elektromagnetisch gekoppelt ist;
ein Ende der ersten Mikrostreifenleitung, das dem Mittenpunkt (4c) der zweiten Mikrostreifenleitung entspricht, hochfrequenzmäßig geerdet ist;
die unsymmetrischen Schwingungssignale dem anderen Ende der ersten Mikrostreifenleitung zugeführt werden; und
von den zugehörigen Ende der zweiten Mikrostreifenleitung (5, 6) symmetrische Schwingungssignale abgegeben werden.

2. Spannungsgesteuerter Oszillator nach Anspruch 1, mit einem Mehrschichtensubstrat (21), auf dem die erste Mikrostreifenleitung (3) und die zweite Mikrostreifenleitung (4) angeordnet sind, wobei:
das Mehrschichtensubstrat (21) eine geerdete leitende Schicht (21 b) sowie eine erste Isolierschicht (21a) und eine zweite Isolierschicht (21c), die oberhalb und unterhalb der leitenden Schicht (21 b) laminiert sind, aufweist;
auf der oberen Oberfläche der ersten Isolierschicht (21a) die erste Mikrostreifenleitung (3) und ein Teil (4a) der zweiten Mikrostreifenleitung (4) in einem Bereich von einem Mittenpunkt (4c) davon bis zu einem Ende einander entgegengesetzt und elektromagnetisch gekoppelt sind;
auf der unteren Oberfläche der zweiten Isolierschicht (21c) ein Teil (4b) der zweiten Mikrostreifenleitung (4) in einem Bereich von dem Mittenpunkt (4c) zu dem anderen Ende vorgesehen ist; und
ein Ende des Teils (4b) der zweiten Mikrostreifenleitung (4), der einem hochfrequenzmäßig geerdeten Ende der ersten Mikrostreifenleitung (3) auf der oberen Oberfläche der ersten Isolierschicht (21 a) entspricht, und ein Ende des Teils (4b) der zweiten Mikrostreifenleitung auf der unteren Oberfläche der zweiten Isolierschicht (21c) mittels eines Durchgangslochs in leitende Verbindung gebracht werden.

## Revendications

1. Oscillateur commandé en tension comprenant :
une partie oscillante qui fournit des signaux d'oscillation non équilibrés ;
une première ligne microruban (3) dont la longueur est le quart de la longueur d'onde des signaux d'oscillation ; et
une seconde ligne microruban (4) dont la longueur est la moitié de la longueur d'onde des signaux d'oscillation, dans lequel :
l'intégralité de la première ligne microruban (3) et de la seconde ligne microruban (4), dans une plage (4a) située entre une extrémité de celle-ci et un point central (4c) dans le sens de la longueur de celle-ci, sont opposées l'une à l'autre et couplées électromagnétiquement ;
une extrémité de la première ligne microruban correspondant au point central (4c) de la seconde ligne microruban est mise à la masse à haute fréquence ; les signaux d'oscillation non équilibrés sont introduits à l'autre extrémité de la première ligne microruban ; et
des signaux d'oscillation équilibrés sont fournis par les extrémités respectives de la seconde ligne microruban (5, 6).

2. Oscillateur commandé en tension selon la revendication 1, incluant un substrat multicouche (21) sur lequel la première ligne microruban (3) et la seconde ligne microruban (4) sont disposées, dans lequel :
le substrat multicouche (21) a une couche conductrice mise à la masse (21b), ainsi qu'une première (21a) et une seconde (21c) couches isolantes stratifiées au-dessus et au-dessous de la couche conductrice (21b) ;
sur la surface supérieure de la première couche isolante (21a), la première ligne microruban (3) et une partie (4a) de la seconde ligne microruban (4), dans une plage située entre un point central (4c) de celle-ci et une extrémité de celle-ci, sont opposées l'une à l'autre et couplées électromagnétiquement ;
sur la surface inférieure de la seconde couche isolante (21c), une partie (4b) de la seconde ligne microruban (4), dans une plage située entre un point central (4c) de celle-ci et l'autre extrémité de celle-ci, est prévue ; et
une extrémité de la partie (4a) de la seconde ligne microruban (4) correspondant à une extrémité mise à la masse à haute fréquence de la première ligne microruban (3) sur la surface supérieure de la première couche isolante (21a), et l'une ou l'autre des deux extrémités de la partie (4b) de la seconde ligne microruban sur la surface inférieure de la seconde couche isolante (21c), sont mises en liaison conductrice par un trou traversant (22).
